# EUROPÄISCHE PATENTANMELDUNG

(11) **EP 2 141 796 A2**
(43) Veröffentlichungstag der Anmeldung: **06.01.2010**
(21) Anmeldenummer: 09164452.6
(22) Anmeldetag: 02.07.2009
(51) Int. Cl.: H03D 1/00

(54) **Empfängervorrichtung, Verwendung einer Empfängervorrichtung, System sowie Verfahren zum energiearmen Empfang von Daten**

(30) Priorität: 02.07.2008 DE 102008031406
(71) Anmelder: EnOcean GmbH, 82041 Oberhaching (DE)
(72) Erfinder: Schmidt, Frank, 82054 Altkirchen (DE)
(74) Vertreter: Epping - Hermann - Fischer

(57) **Zusammenfassung**

Die Erfindung bezieht sich auf eine Empfängervorrichtung, ein System beziehungsweise ein Verfahren zum Empfang eines mit Informationen amplitudenmodulierten Signal, wobei ein resistives Element vorgesehen ist, welches eine elektrische Größe in einen physikalischen Parameter umsetzt.

## Beschreibung

Die Erfindung bezieht sich auf eine Empfängervorrichtung, ein System sowie ein Verfahren zum Empfangen eines mit Informationen amplitudenmodulierten Signals.

Aufgrund bestehender Normen dürfen Sendeeinrichtungen funkbetriebener Systeme festgelegte Sendeleistung nicht überschreiten. Eine typische maximale Sendeleistung ist beispielsweise 10 mW. Dies entspricht einem maximalen Sendepegel von 10 dBm. Durch diese Einschränkungen der Sendeleistung ist die Reichweite für eine erfolgreiche Übertragung von Informationen sehr stark von der Beschaffenheit der Empfängervorrichtung abhängig. Ein hinlänglich bekanntes Problem, welches in der Funktechnik zu lösen gilt, ist die Konstruktion von Empfängervorrichtungen, die eine hohe Empfindlichkeit für die zu empfangenden Signale aufweisen, dabei aber selbst wenig Energie für den richtigen Empfang dieser gesendeten Signale verwenden.

Der Empfangspegel ist gegenüber dem Sendepegel stark bedämpft. Verursacht wird diese Dämpfung durch die Freiraum-übertragung, Stör- und Umwelteinflüsse. Heutige Funksysteme können durchaus hohe Reichweiten erzielen, allerdings ist dazu ein aufwendiges Schaltungskonzept in den Empfängervorrichtungen vorzusehen, wodurch diese Empfängervorrichtungen selbst sehr viel Energie benötigen. Als aufzuwendende Schaltungskonzepte seien hier beispielhaft aufwendige Verstärkerschaltungen, Korrelationsempfänger oder digitale Filter mit digitalen Rechenwerken genannt.

Entscheidend in der Empfängertechnik ist der kleinstmögliche Empfangspegel, bei dem ein Signal noch richtig in einer Empfangsvorrichtung empfangen werden kann. Der kleinstmögliche Empfangspegel wird auch als die Empfindlichkeit der Empfängervorrichtung bezeichnet. Die Empfindlichkeit ergibt sich dabei aus der effektiven Rauschleistung und dem erforderlichen minimalen Signal-Rausch-Verhältnis des Empfangssignals. Die Rauschleistung ergibt sich wiederum aus der thermischen Rauschleistungsdichte N₀, der Bandbreite B und der Rauschzahl F der Empfängervorrichtung. Da die Rauschleistungsdichte mit k*T₀ = 4 • lO⁻²¹ Watt bzw. -174dBm pro Hertz Bandbreite und die Bandbreite bei genormten Funksystemen konstant sind, kann die Empfindlichkeit am effektivsten über die Rauschzahl F der Empfängervorrichtung erhöht werden. Es ist daher anzustreben, rauscharme Empfängervorrichtungen zu entwickeln, da diese eine hohe Empfindlichkeit aufweisen.

Ist eine Empfängervorrichtung aufzubauen, die nur wenig Versorgungsenergie zur Verfügung hat oder wenig Energie zum richtigen Empfang pegelschwacher Signale aufwenden soll, können hohe Reichweiten mit herkömmlichen Schaltungskonzepten nicht erzielt werden. Dieses Problem stellt sich insbesondere bei energieautarken oder batteriebetriebenen Empfangsvorrichtungen, die beispielsweise nach dem Energy harvesting Prinzip funktionieren. Hierbei wird die Versorgungsenergie aus der Umgebung gewonnen.

Wünschenswert sind verarbeitbare Empfangspegel, die 100 dB und mehr unter dem Sendepegel von 10dBm liegen. Dabei sollte die Empfängervorrichtung weniger als einige 100µW für den Empfang der Signale aufwenden, um die Energieressourcen zur Versorgung der Empfängervorrichtung möglichst lange nutzen zu können. Eine höhere Energieaufnahme führt zwangsläufig zu einem höheren Energieverbrauch und damit zu einer schnelleren Erschöpfung der Energieressource.

Herkömmlich erfolgt die Demodulation eines amplitudenmodulierten Signals im Empfänger mit einem Hüllkurvendetektor, der zumindest eine Diode im Signalpfad zur Gleichrichtung des Empfangssignals aufweisen. Ein nachgeschaltetes Tiefpassglied filtert die hohen Frequenzanteile des empfangenen Signals heraus. Diese Art der Demodulation ist sehr ineffektiv bei der Verarbeitung kleiner Empfangspegel. Die Dioden besitzen zunächst nichtlineare Kennlinien. Speziell im Unterschwellspannungsbereich weisen Dioden einen geringen Wirkungsgrad auf. Zwar werden in der Hochfrequenztechnik speziell gefertigte Dioden verwendet, die verbesserte Wirkungsgrade aufweisen, allerdings sind weiterhin Parasitäreffekte vorhanden. Wird ein Demodulator mittels Dioden realisiert, können kleinere Empfangspegel von der Empfängervorrichtung, typischerweise kleiner -50dBm, nicht mehr richtig empfangen werden.

Um kleinere Empfangspegel noch richtig empfangen zu können werden bislang aufwendige Schaltungskonzepte angewandt. Beispielsweise werden Hochfrequenzverstärker eingesetzt. Diese Hochfrequenzverstärker weisen eine minimale Stromaufnahme von einigen 10mA bis 100 mA auf. Diese Stromaufnahme führt speziell bei energieautarken oder batteriebetriebenen Empfängervorrichtungen zu einem schnellen Verbrauch der Energieressourcen und ist daher unerwünscht.

Eine angestrebte Stromwertamplitude, die von dem Empfänger fehlerfrei empfangen werden sollte, ist beispielsweise 1µA. Dies entspricht einem Empfangsleistungspegel von -90dBm.

Aus der EP 1 449 309 B1 ist eine Aktivierungseinrichtung für ein fernauslösbares Schaltungssystem bekannt, bei der ein Aktivierungssignal mittels eines speziellen Heizelements in Wärme umgewandelt wird. Ein pyroelektrisches Element erfasst die Erwärmung des Heizelements. Mittels einer nachgeschalteten Aktivierungsschaltung wird eine herkömmliche Empfängerschaltung für den Empfang aktiviert.

Nachteilig ist hierbei, dass zunächst Zeit und Energie aufgewendet werden muss, um die eigentliche Empfängervorrichtung zu aktivieren. Zusätzlich ist mit der aufgezeigten Aktivierungsschaltung kein energiearmes Empfangen mit einer hohen Empfindlichkeit der Empfängervorrichtung erzielt, sondern lediglich das Horchen, ob ein Signal vorhanden ist, energieärmer ausgestaltet.

Es stellt sich die Aufgabe, eine Empfängervorrichtung mit einer hohen Empfindlichkeit bereitzustellen, wobei der Energiebedarf der Empfängervorrichtung minimiert ist, um ein gesendetes Signal zu empfangen.

Diese Aufgabe wird mit den in den nebengeordneten Patentansprüchen beschriebenen Maßnahmen gelöst.

Es ist eine Empfängervorrichtung mit einer Antenne beschrieben, wobei die Antenne ausgebildet ist, eine mit Informationen amplitudenmodulierte elektrische Größe ausgangsseitig bereitzustellen. Der Antenne ist ein resistives Element derart nachgeschaltet, dass es mit der amplitudenmodulierten elektrischen Größe belastet wird. Dem resistiven Element ist eine Auswerteeinheit nachgeschaltet, wobei die Auswerteeinheit zumindest einen physikalischen Parameter des resistiven Elements auswertet. Der physikalische Parameter variiert aufgrund der Amplitudenmodulation der elektrischen Größe. Am Ausgang der Auswerteeinheit wird durch einen Vergleich einer Änderung des physikalischen Parameters gegenüber einer Belastung des resistiven Elementes mit einer unmedulierten elektrischen Größe die Information bereitgestellt.

Durch das Einbringen des resistiven Elements in die Empfängervorrichtung sind weniger Parasitäreffekte als im Vergleich zum Einbringen von Dioden enthalten, die die Demodulation uneffektiv machen würden. Dadurch weist die Empfängervorrichtung eine höhere Empfindlichkeit auf und kann amplitudenmodulierte Empfangspegel richtig empfangen und demodulieren, die um eine Vielzahl von Größenordnungen kleiner als der Sendepegel ist.

Da das resistive Bauelement eine nahezu lineare Kennlinie aufweist, sind Eingangs- und Ausgangsgrößen des Empfängers zumindest über einen sehr großen Empfangspegelbereich proportional. Die Empfindlichkeit ist dadurch wesentlich höher als bei der Verwendung von Dioden. Dadurch ist das Empfangen von sehr kleinen Pegeln möglich, ohne aufwendige Schaltungskonzepte, beispielsweise Hochfrequenzverstärker, verwenden zu müssen. Durch eine entsprechende Dimensionierung des resistiven Elements ist es möglich, die Änderungen der physikalischen Parameter mit den Änderungen der amplitudenmodulierten elektrischen Größen ins Verhältnis zu setzen.

Weitere vorteilhafte Ausgestaltungen sind in den untergeordneten Patentansprüchen beschrieben.

Als Amplitudenmodulation wird bevorzugt eine Amplitude Shift Keying, kurz ASK, verwendet. Durch 100% Austastung der Amplitude, was dem On Off Keying, kurz OOK, entspricht, ist eine maximale Veränderung der physikalischen Parameter des resistiven Elements erzeugt.

Als physikalischer Parameter ist beispielsweise die Temperatur gewählt. Das resistive Element ändert seine Temperatur durch die Änderungen der amplitudenmodulierten elektrischen Größe. Diese Temperaturänderung ist mit einfachen schaltungstechnischen Mitteln detektierbar, wobei der Energiebedarf der Empfängervorrichtung zum richtigen Empfang gering bleibt.

Andere auswertbare physikalischen Parameter sind der elektrische Leitwert, die Länge und die Lichtstärke.

Befindet sich in der nachgeschalteten Auswerteeinheit ein thermisches Sensorelement, so ist dieser Temperaturunterschied am resistiven Element sehr einfach detektierbar. Vorteil dieser Ausgestaltung ist das rückschlussfreie Arbeitsprinzip ist. Ein thermisches Sensorelement ist beispielsweise ein pyroelektrischer Sensor. Alternativ wird ein thermoelektrischer Sensor verwendet, der beispielsweise den Peltier- oder Seebeckeffekt zum Detektieren des Temperaturunterschieds ausnutzen.

Bevorzugt wird die elektrische Leitfähigkeit ausgewertet, wenn das resistive Element als ein Thermistor oder als ein Varistor ausgebildet ist.

Bevorzugt ist zumindest das resistive Element in Mikrotechnik oder Nanotechnik hergestellt. Strukturgrößen im Nanometerbereich sind heutzutage problemlos realisierbar. Dadurch weist das resistive Element sehr kleine Dimensionen auf, wodurch die physikalischen Parameter des resistiven Elements sehr gut ausgewertet werden können. Werden weitere Elemente der Empfängervorrichtung in Mikrotechnik hergestellt, ist der Einfluss von Störgrößen minimiert und die gesamte Empfängervorrichtung empfindlicher gegenüber geringer Empfangspegel.

In einer weiteren Ausgestaltung weist die Auswerteeinheit eine Differenzeinheit auf. Diese Differenzeinheit weist einen ersten und einen zweiten Eingang sowie einen Ausgang aufweist. Am ersten Eingang wird der variierende physikalische Parameter des resistiven Elements zunächst in eine elektrische Größe umgesetzt und anschließend dem ersten Eingang der Differenzeinheit bereitgestellt. Am zweiten Eingang wird der gleiche physikalische Parameter eines resistiven Referenzelements ebenfalls zunächst in eine elektrische Größe unabhängig von dem von der Antenne bereitgestellten elektrischen Größe umgesetzt und anschließend dem zweiten Eingang der Differenzeinheit bereitgestellt. Am Ausgang wird die Differenz der beiden elektrischen Größen bereitgestellt. Das resistive Referenzelement ist dabei isoliert von der amplitudenmodulierten elektrischen Größe angeordnet, sodass diejenigen variierenden physikalische Parameteränderungen, die nicht von der variierenden elektrischen Größe verursacht werden, in der Differenzeinheit kompensiert werden. Da der physikalische Parameter zusätzlich von Umgebungsvariablen, beispielsweise der Umgebungstemperatur, Vibrationen und elektromagnetischen Störeinflüssen, abhängt, verhält sich der Parameter nicht zwingend linear verhält. Durch diese Ausgestaltung lassen sich additive Störungen sehr einfach kompensieren.

In einer weiteren Ausgestaltung ist zwischen Antenne und resistivem Element ein das Frequenzband der elektrischen Größe begrenzendes Element angeordnet. Da die Antenne meist sehr breitbandig empfängt, können durch diese Maßnahme Frequenzanteile herausgefiltert werden, die nicht zum Spektrum des amplitudenmodulierten Sendesignals gehören.

In einer weiteren Ausgestaltung weist die Empfängervorrichtung eine Korrelationseinheit in der Auswerteeinheit aufweist. Dadurch werden Identifikationsmerkmale erkannt, die in dem Empfangssignal vorhanden sind. Die Empfängervorrichtung erkennt somit, ob das empfangene Signal für diese Empfängervorrichtung vorgesehen ist. Bei einem positiven Korrelationsergebnis wird das Informationssignal weitergeleitet und eine nachgeschaltete Einheit aktiviert. Bei einem negativem Korrelationsergebnis wird das Informationssignal nicht weitergeleitet und die nachgeschaltete Einheit bleibt in einem deaktivierten Zustand. Durch eine Korrelationseinheit ist die Empfängervorrichtung empfindlicher und kann somit kleinere Empfangspegel richtig verarbeiten. Ist das Eingangssignal stark verrauscht kann mittels geeigneter Korrelationsalgorithmen in der Korrelationseinheiten das Informationssignal trotz hohem Rauschpegels errechnet werden.

Zusätzlich kann eine Überpegelschutzeinrichtung in der Empfängervorrichtung vorgesehen sein, wodurch sichergestellt ist, dass das resistive Element nicht mit einer Überspannung beziehungsweise einem Überpegel belastet wird. Durch dieses Überbelasten würde das resistive Element möglicherweise zerstört werden, zumindest aber nicht korrekt arbeiten.

Weiterhin ist vorgesehen, ein verstärkendes und ein das Frequenzband begrenzendes Element am Ausgang der Auswerteschaltung einzubringen, wodurch das demodulierte Signal stabiler und besser verarbeitbar ist.

Es ist weiterhin ein System mit einer Sendevorrichtung und zumindest einer Empfängervorrichtung vorgesehen. Hierbei nimmt ein Sensor Daten auf und übermittelt diese einer Sendevorrichtung. Die Sendevorrichtung moduliert diese Daten mittels Amplitudenmodulation und überträgt die Daten somit an eine Empfängervorrichtung. Die Empfängervorrichtung stellt am Ausgang die Daten demoduliert zur Verfügung.

Bislang werden Funksystem im Zeitschlitzverfahren betrieben, um Energie einzusparen. Dies sind Synchronverfahren, die ein Zeitmanagement benötigen. Das heißt, dass Sende- und Empfängervorrichtung sich einen Zeitpunkt vereinbaren, indem das zu übertragende Datum gesendet wird. Dies erfolgt in einem bestimmten Zeitintervall, beispielsweise eine 10ms Sendung innerhalb einer Minute. Außerhalb des Sendezeitpunktes sind Sende- und/oder Empfängervorrichtung deaktiviert. Dies hat den Nachteil, dass eine Änderung eines Datums an einem Sensor erst zu dem vereinbarten Zeitpunkt übertragen wird. Ändert sich der Wert bis dahin erneut, kommt es zu einem unerwünschten Datenverlust. Beispielsweise ist die Übertragung eines Temperaturwertes über ein solches System unkritisch, da sich ein Temperaturwert nur langsam ändert. Allerdings gibt es zeitkritische Anwendungen. Beispielsweise in der Gefahrensensorik, bei Schaltelementen ist eine Echtzeitübertragung unumgänglich.

Deshalb besteht dieses System aus mehreren Sender- und Empfängervorrichtungen. Hierbei enthält jedes gesendete Signal eine spezielle Identifikationsmarke mit der jeweils eine bestimmte Empfängervorrichtung angesprochen wird. Erkennt eine Empfängervorrichtung, dass sie nicht angesprochen ist, blockiert die Empfängervorrichtung die Daten. Dies ist beispielsweise mittels Korrelationsberechnung realisierbar. Mittels eines solchen Systems können beispielsweise Funkschalter betrieben werden.

Das System arbeitet voll asynchron, was bedeutet, dass ein Echtzeitbetrieb möglich ist. Wenn ein Datum bzw. eine Information an einem Sensor zur Verfügung steht wird es ad hoc durch die Sendevorrichtung amplitudenmoduliert und versendet. Gegebenenfalls wird die Sendevorrichtung eine Identifikationsmarke in das Sendesignal einfügen, um eine bestimmte Empfängervorrichtung anzusprechen. Ein möglicher Datenverlust ist somit unterbunden.

Zur Weiterverarbeitung wird das demodulierte Signal in der Empfängervorrichtung in einer weiteren Ausgestaltung des Systems einer nachgeschalteten Einheit zur Verfügung gestellt. Dazu sind beispielsweise Bussysteme vorgesehen, an denen jede Empfängervorrichtung angeschlossen ist. Durch das Vernetzen der Empfangsvorrichtungen ist es zusätzlich möglich, dass das Datum bzw. die Information über mehrere Wege gleichzeitig versendet wird.

Alternativ arbeitet die Empfängervorrichtung als Repeater und regeneriert das empfangene Signal. In diesem Fall weist die Empfängervorrichtung ein weiteres Modul auf, welches das regenerierte Signal erneut moduliert und versendet.

Das System weist in einer alternativen Ausgestaltung energieautarke Knoten auf, die zumindest teilweise mit den beschriebenen Empfängervorrichtungen ausgestattet sind, um ein Signal auch über große Reichweiten empfangen und weiterleiten zu können. Hierbei sind die energieautarken Knoten mittels Umgebungsenergie, beispielsweise Solarenergie, versorgt.

Eine erfindungsgemäße Empfängervorrichtung findet beispielsweise Verwendung als Teil in einem Funksensornetz. Das Funksensornetz kann einige batteriebetriebene Vermittlungs- oder Verteilungsknoten aufweisen. Zusätzlich oder alternativ können diese Knoten energieautark sein. Informationen innerhalb des Funksensornetzes werden mittels geeigneter Routingverfahren weitergeleitet.
Als "Routing", englisch für "Lotsen", "Wegewahl", "Verkehrslenkung" wird in der Telekommunikation das Festlegen von Wegen für Nachrichtenströme bei der Nachrichtenübermittlung über vermaschte Nachrichtennetze bzw. Rechnernetze bezeichnet. Das Routing bestimmt den gesamten Weg eines Nachrichtenstroms durch das Netzwerk.

Beispielhafte Routingverfahren, mit denen das erfindungsgemäße System betrieben werden kann, sind in der Anmeldung "Initialisierungsverfahren und Betriebsverfahren für ein Funknetzwerk", Erfindungsakte P2008,0736 DE E der gleichen Anmelderin beschrieben. Das amtliche Aktenzeichen ist zum Anmeldezeitpunkt nicht bekannt und wird nachgereicht.

Schließlich ist ein Verfahren zum energiesparenden Detektieren von amplitudenmodulierten Signalen vorgesehen, wobei in einem ersten Verfahrensschritt das Umsetzen einer veränderlichen elektromagnetischen Größe in eine elektrische Größe vorgesehen ist, danach eine Umsetzung der elektrischen Größe in eine andere physikalische Größe mittels resistivem Elements durchgeführt wird, danach eine Auswertung der physikalischen Größe aufgrund der Amplitudenveränderung variiert und schließlich das Auswerteergebnis als unmoduliertes Signal interpretiert wird.

Nachfolgend wird die Erfindung anhand von Ausführungsbeispielen mit Bezugnahme auf die Figuren näher beschrieben. Hierbei werden gleiche oder gleich wirkende Bestandteil der Figuren mit gleichen Bezugszeichen versehen. Einzelne Elemente können hierbei übertrieben groß, beziehungsweise übertrieben vereinfacht dargestellt sein.

Es zeigen:
Figur 1 ein Funkübertragungssystem,
Figur 2 ein erstes Ausführungsbeispiel einer erfindungsgemäßen Empfängervorrichtung,
Figur 3 eine Weiterbildung der in Figur 2 dargestellten Empfängervorrichtung,
Figur 4 eine Weiterbildung der in Figur 2 dargestellten Empfängervorrichtung,
Figur 5 eine Weiterbildung der in Figur 2 dargestellten Empfängervorrichtung,
Figur 6 eine Weiterbildung der in Figur 2 dargestellten Empfängervorrichtung,
Figur 7 ein erfindungsgemäßes System mit Sendevorrichtung und Empfangsvorrichtung,
Figur 8 ein alternatives System zu dem in Figur 7 dargestellten System,
Figur 9 ein erfindungsgemäßer Systemverbund von Empfängervorrichtungen
Figur 10 ein typischer Signalverlauf einer in Figur 3 dargestellten Empfängervorrichtung.

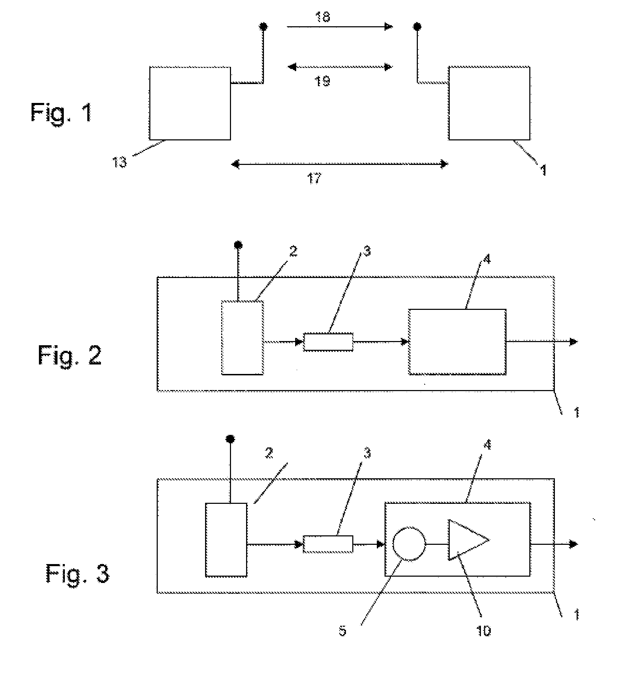

Das in Figur 1 dargestellte Prinzip verdeutlicht die eingangs beschriebene Problematik. Eine Sendevorrichtung 13 sendet ein amplitudenmoduliertes Signal mit beispielsweise einer Maximalleistung von 10mW beziehungsweise +10 dBm aus. Eine entfernte Empfängervorrichtung 1 empfängt dieses amplitudenmodulierte Signal. Eine Übertragung ist hierbei unidirektional und auch bidirektional möglich. Im einfachen und stromsparenden Fall ist die Übertragung unidirektional von Sendevorrichtung 13 zu Empfängervorrichtung 1. Aufgrund der hohen Entfernung ist eine hohe Pegeldämpfung, hier beispielsweise 100dB zu erwarten. Die Pegeldämpfung begründet sich in der Freiraumdämpfung, Stör- und Umwelteinflüssen. Bei einem Sendepegel von +10dBm und einer Dämpfung von 100dB liegt ein Empfangspegel von -90dBm an, was einer Empfangsleistung von 10nW entspricht.

Zur Informationsübertragung werden die zu übertragenden Informationen in der Sendevorrichtung 13 amplitudenmoduliert und anschließend übertragen. Vorteilhaft ist ein großer Amplitudenhub, idealerweise ist der Amplitudenhub gleich 1, da dieser eine stark schwankende Amplitude des Sendesignals herbeiführt. Zusätzlich ist das Verhältnis aus Trägerfrequenz zu Informationsfrequenz größer 1000. Typische Trägerfrequnzen liegen zwischen 100 MHz und 10 GHz. Beispielsweise weist ein Informationssignal eine Frequenz von 100kHz bzw. 100 kBit/s bei digitalen Informationssignalen, auf.

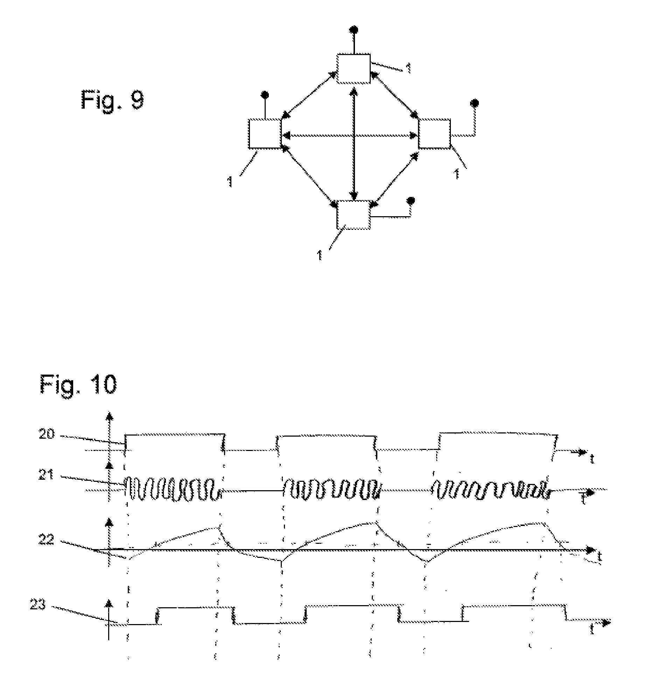

Bevorzugt ist das Informationssignal digitaler Natur und wird mittels digitaler Amplitudenmodulation, beispielsweise Amplitude-Shift-Keying (ASK), übertragen. Hierbei ist das On Off Keying (OOK) ein bevorzugtes Verfahren, da ein erster binärer Zustand der Information ohne Trägerfrequenz, ein zweiter binärer Zustand der Information mit der viel höherer Trägerfrequenz übertragen wird. Dies entspricht einer Amplitudenaustastung von 100%. In Figur 10 ist ein typischer Signalverlauf eines digitalen Informationssignals 20 und eines modulierten Signals 21 dargestellt. Die Daten bzw. Informationen sind hierbei beispielsweise Sensordaten.

Die Übertragung von Informationen bzw. Daten findet hierbei bevorzugt in den ISM- Frequenzbänder statt. Die ISM-Bänder sind durch die Internationale Fernmeldeunion, Sektor Radiokommunikation (ITU-R) festgelegt. Abhängig von der Region, in der eine solche Funkübertragung stattfindet, sind bevorzugte Frequenzen zu verwenden. Beispielsweise ist in der US Region bevorzugt eine Frequenz von 315 MHz, in der EU Region die Frequenzen 868 MHz bzw. 2,4 - 2,5 GHz verwendet. Die Übertragung kann ebenso protokollbasiert vorgenommen sein. Hierbei sind beispielhaft die Standards Bluetooth, ZigBee und Z-Wave mit den entsprechenden Übertragungsfrequenz genannt.

In Figur 2 ist ein erstes Ausführungsbeispiel der Empfängervorrichtung 1 beschrieben. Diese Empfängervorrichtung 1 beinhaltet eine Antenne 2, ein nachgeschaltetes resistives Element 3 und eine dem resistiven Element 3 nachgeschaltete Auswerteeinheit 4.

Die Antenne 2 setzt eine veränderliche elektromagnetische Feldgröße in eine amplitudenmodulierte elektrische Größe um und stellt diese elektrische Größe am Ausgang bereit. Beispielsweise ist die Antenne eine Dipolantenne. Das nachgeschaltete resistive Element 3 wandelt diese elektrische Größe in einen physikalischen Parameter um. Als resistives Element ist bevorzugt ein elektrischer Widerstand eingesetzt. Die nachgeschaltete Auswerteeinheit 4 wertet diesen physikalischen Parameter aus, wobei dieser Parameter mit der Amplitude des empfangenden Signals variiert. In Figur 10 ist beispielhaft das Variieren des physikalischen Parameters Temperatur 22 in Abhängigkeit vom modulierten Signal 21 dargestellt. Am Ausgang der Auswerteeinheit 4 steht das detektierte Informationssignal 23 zur Verfügung, welches dem ursprünglichen Signal entspricht.

Als resistives Element 3 wird ein Zweipolelement der Elektrotechnik verstanden, welches eine weitestgehende Proportionalität zwischen Strom und Spannung aufweist. Der Strom und die Spannung sind dabei in Phase. Dieses resistive Element 3 weist physikalische Parameter auf, die sich entweder proportional zu einer Änderung der amplitudenmodulierten elektrischen Größe ändern oder deren Änderungen sich mit jeder Trägerfrequenzschwingung betragsmäßig aufsummieren. Als physikalische Parameter seien hier beispielsweise die Temperatur, die Leitfähigkeit und die Länge genannt. Diese Parameter werden nun mittels geeigneter Sensorik ausgewertet.

Wird die Temperatur als physikalischen Parameter analysiert, sind insbesondere Sensoren verwendet, die die Wärmestrahlung des resistiven Elements 3 detektiert. Durch das Detektieren der variierenden Wärmestrahlung ist ein rückwirkungsfreies Auslesen des Empfangspegels möglich. Das resistive Element 3 wird dabei nicht belastet. Alternativ ist auch ein Sensorelement verwendbar, welches die Wärmeleitfähigkeit als variierenden physikalischen Parameter des resistiven Elements auswerten. Alternativ werden Sensoren verwendet, die physikalische Parameter auswerten, die sich von der Wärmeänderung herleiten lassen.

Ohne empfangene und angelegte elektrische Größe bewegen sich die Elektronen ungeordnet im Atomgitter des resistiven Elements 3, was auch als Brownsche Bewegung bezeichnet wird. Wird nun eine amplitudenmodulierte elektrische Größe an das resistive Element gelegt, so werden die freien Elektronen innerhalb des Gitters durch das elektrische Feld in Richtung der Feldlinien beschleunigt. Es fließt ein elektrischer Strom.

Auf ihrem Weg durch das resistive Element kommt es zu elastischen Stößen der Elektronen mit anderen Elektronen. Dabei geben die Elektronen Energie an ihre Stoßpartner ab. Die Elektronen werden durch diese Stöße dauernd abgebremst und es stellt sich eine mittlere Strömungsgeschwindigkeit ein. Zusätzlich wird nicht die gesamte Energie zum Stoßpartner übertragen, ein Teil dieser Energie wird in andere Energieformen, beispielsweise thermische Energie, umgesetzt.

Bei amplitudenmodulierten Signalen ist das Verhältnis von Trägerfrequenz zu Informationssignalfrequenz idealerweise groß gewählt. Beispielsweise kann eine 1Bit Information zigtausende Trägerfrequenzschwingungen aufweisen. Bei einer Datenrate von 125kBit/s ist die Zeitdauer eines Bits 8µs. Dies ist in Figur 10 nur angedeutet. Jede dieser Trägerfrequenzschwingung, die sowohl positive als auch negative Spannungsamplituden aufweist, erzeugt in dem resistiven Element 3 eine Veränderung des zu untersuchenden physikalischen Parameters.

Durch diese veränderlichen physikalischen Parameter ist in der Auswerteeinheit die Änderung der amplitudenmodulierten elektrischen Größe gut detektierbar.

Durch eine entsprechende Dimensionierung des resistiven Elements 3 ist es möglich, die Änderungen der physikalischen Parameter mit den Änderungen der amplitudenmodulierten elektrischen Größen in ein gut auswertbares Verhältnis zu setzen.

Im Folgenden wird nun beispielhaft eine Möglichkeit beschrieben, wie ein physikalischer Parameter des resistiven Elements 3 ausgewertet wird.

Für ein resistives Element 3 kommen insbesondere Materialien in Betracht, die bereits heutzutage standardmäßig in der Mikrotechnologie verwendet werden. Beispielhaft ist in der folgenden Betrachtung ein resistives Element 3 aus Aluminium verwendet. Einige wesentliche Parameter vom Aluminium sind hier aufgelistet:

| | |
|---|---|
| - Spezifischer Widerstand Rho: | =2,64 * 10^(-8) Ohm*m |
| - Spezifische Materialdichte d: | =2700 Kg/m^3 |
| - Spezifisch Wârmekapazität c: | =900 J/Kg*K) |

Um Änderungen der physikalischen Parameter gut detektieren zu können, ist das resistive Element möglichst klein auszubilden. Das heißt, die Abmessungen des resistiven Elements sollten sehr gering sein, um eine ausreichende Änderung bei geringen Empfangspegeln zu erzielen. Es werden im folgenden Strukturgrößen eines resistiven Elements aufgelistet, die heute bereits in entsprechender Mikro- oder Nanotechnik prozessierbar sind.

| | |
|---|---|
| Länge l: | =180 nm |
| Höhe h: | =4,5 nm |
| Breite b: | =90 nm |

Daraus ergibt sich ein Gewicht m des resistiven Elements 3 von:

| | |
|---|---|
| m=l*b*h*d | =1,97*10^(-19) Kg |

und ein ohmscher Gleichstromwiderstand R des resistiven Elements 3 von:

| | |
|---|---|
| R=Rho*l/(h*b) | =11,7 Ohm |

Der Widerstand R des resistiven Elements 3 ist von Bedeutung, um eine effiziente Hochfrequenzleistungsanpassung an die Empfangsantenne zu erhalten. Ohmsche Wirkwiderstände R zwischen etwa 5 Ohm und 300 Ohm erfüllen diese Bedingung gut.

In Figur 3 ist eine Weiterbildung der in Figur 2 dargestellten Empfängervorrichtung 1 aufgezeigt. Im Folgenden wird lediglich auf die Unterschiede zu Figur 2 eingegangen, um Wiederholungen zu vermeiden. In Figur 3 weist die Auswerteeinheit 4 zusätzlich einen Temperatursensor 5 auf. Dieser Temperatursensor 5 ist beispielsweise ein pyroelektrischer oder ein thermoelektrischer Sensor.

Die benötigte Energie für einen Kelvin Temperaturänderung am Sensorelement errechnet sich aus:

| | |
|---|---|
| E=c*m | =1,77*10^(-16) Ws/K |

Das bedeutet, es wird eine Energiemenge von 1,77*10^(-16) Ws benötigt, um beispielsweise einen Temperatursensor 5 um 1K zu erwärmen. Dabei wurde zunächst vernachlässigt, dass sich auch die Umgebung des Temperatursensors 5 mit erwärmt, wodurch der Effekt geringer ausfällt.

Beispielsweise wird in der Empfängervorrichtung 1 wie eingangs beschrieben eine Grenzempfindlichkeit des Empfängers von -95 dBm angestrebt. Dieses Ziel muss mit der gewählten Bandbreite der Funkübertragung zusammen betrachtet werden.

Die minimale Empfangsleistung P0 bei -95dBm ist somit:

| | |
|---|---|
| P0 | =3,16*10^(-13) W |

Die Zeitlänge eines digitalen "1" Bits bei einer Datenrate von 125kBit/s beträgt 8 µs, woraus eine Energie E1 einer logischen 1 gleich:

| | |
|---|---|
| E1 | =2,53*10^(-18) Ws |

entspricht. Die resultierende Temperaturerhöhung bei einem empfangenen "1" Bits an einem resistiven Elements mit obigen Abmessungen ist somit:

| | |
|---|---|
| dT=E1/E | =0,014K. |

Diese Rechnung zeigt, dass bei der gewählten Dimensionierung des resistiven Elements 3 mit einer Erwärmung in der Größenordnung von 1/100 K gerechnet werden kann, wenn ein einzelnes Bit bei Grenzempfindlichkeit empfangen wird.

Dieser Temperatursensor 5 wertet den physikalischen Parameter Temperatur des resistenten Elements 3 aus. Mittels einer Verstärkerschaltung ist am Ausgang der Auswerteeinheit 4 das unmodulierte Signal zur Verfügung gestellt.

Ist der zu untersuchende physikalische Parameter die Temperatur, erzeugt jede Trägerschwingung einen Anstieg der Temperatur in dem resistiven Element 3. Es erfolgt eine Aufsummierung des Temperaturwertes mit jeder Trägerfrequenzschwingung. Durch diese Aufsummierung des Temperaturwertes mit jeder Trägerschwingung ist ein gut detektierbarer Temperaturwertunterschied während einer Informationseinheit, beispielsweise eines Bits, erzeugt. Die Höhe des absoluten Temperaturunterschieds zwischen Beginn und Ende einer Nutzinformationsschwingung wird entscheidend durch das Verhältnis zwischen Trägerfrequenz und Informationsfrequenz bestimmt. Je höher das Verhältnis ist, desto höher ist der Temperaturunterschied zwischen zwei Information.

Ein pyroelektrischer Sensor weist ein polarisiertes Kristall als Material auf, wobei auf dem Kristall auf zwei gegenüberliegenden Seiten, Elektroden aufgebracht sind. Trifft thermische Strahlung auf eine Elektrode, so ändert sich durch den Temperaturunterschied die Polarisation des Kristalls. So wird ein elektrische Signal erzeugt, welches der Information, also dem demodulierten Signal entspricht.

Alternativ ist der spezifische Widerstand als physikalischer Parameter detektierbar. Der spezifische Widerstand oder auch Resistivität, ist eine temperaturabhängige Materialkonstante mit dem Formelzeichen ρ, griechisches Rho. Der elektrische Widerstand eines homogenen resitiven Elements 3 lässt sich aus den Werten des Materials errechnen. Der Kehrwert des spezifischen Widerstands ist die elektrische Leitfähigkeit K, griechisches kappa. Für das Detektieren des Variierens dieses physikalischen Parameters ist die Verwendung von Thermistoren als resistives Element 3 vorzusehen.

Ein Thermistor ist ein temperaturabhängiger elektrischer Widerstand, der seinen Widerstandswert aufgrund eines hohen Temperaturkoeffizienten des materialspezifischen elektrischen Widerstandes unter dem Einfluss der Temperatur gewollt erheblich ändert. Man unterscheidet zwischen Heißleitern, bei denen der Widerstandswert mit steigender Temperatur sinkt, und Kaltleitern, bei denen der Widerstandswert mit steigender Temperatur steigt. Wird die variierende elektrische Größe an den Thermistor angelegt, so wird bei geeigneter Dimensionierung, die Temperatur im Thermistor ansteigen. Diese Temperaturänderung schlägt sich in der Änderung des spezifischen Widerstands wieder, welche wiederum insbesondere mittels Widerstandsmesswerk detektiert werden kann.

Zum Detektieren des elektrischen Leitwertes kann alternativ ein Varistor als resistives Element 3 vorgesehen sein. Ein Varistor ist ein spannungsabhängiger Widerstand. Die Kennlinie ist dabei symmetrisch zur Spannung, die Polarität spielt demnach keine Rolle. Varistoren werden auch als VDR bezeichnet. VDR steht für Voltage Dependent Resistor, also spannungsabhängiger Widerstand.

In einem alternativen nicht dargestellten Ausführungsbeispiel wird zumindest eine geometrische Dimension des resistiven Elements 3 als physikalischer Parameter analysiert. Vorzugsweise wird dabei die Länge untersucht. Mit dem Begriff Länge ist hierbei eine zu untersuchende Dimension des resistiven Elements 3 verstanden, demnach ist keine Einschränkung bezüglich Länge, Breite oder Höhe gegeben. Durch geeignete Dimensionssensorik ist die Veränderung der Länge detektierbar. Unter dem Begriff Länge ist darüber hinaus jegliche Art von mechanischer Deformation zu verstehen, wodurch auch Verbiegungen des resistiven Elements aufgrund der variablen elektrischen Größe.

Die Empfängervorrichtung ist dabei bevorzugt zumindest teilweise in einer Halbleitertechnologie gefertigt. Als Verfahren für diese Herstellung eignen sich Mikrotechnologien, beispielsweise Dünnfilmtechnik, Nanotechnologie oder andere Halbleitertechnologien, in denen das resistive Element präzise gefertigt werden kann. Durch das Integrieren zumindest des resistiven Elements ist erreicht, dass das resistive Element minimale Abmaße aufweist, wodurch bereits minimale Änderungen des zu untersuchenden physikalischen Parameters detektiert werden können.

In einer Weiterbildung werden weitere Einheiten, beispielsweise der Sensor und die Auswerteeinheit der Empfängervorrichtung, integriert, um den Einfluss von Störgrößen, beispielsweise Umgebungstemperatur, Vibration, elektromagnetische Einflüsse minimal zu halten. Idealerweise ist ein Großteil der Empfängervorrichtung integriert.

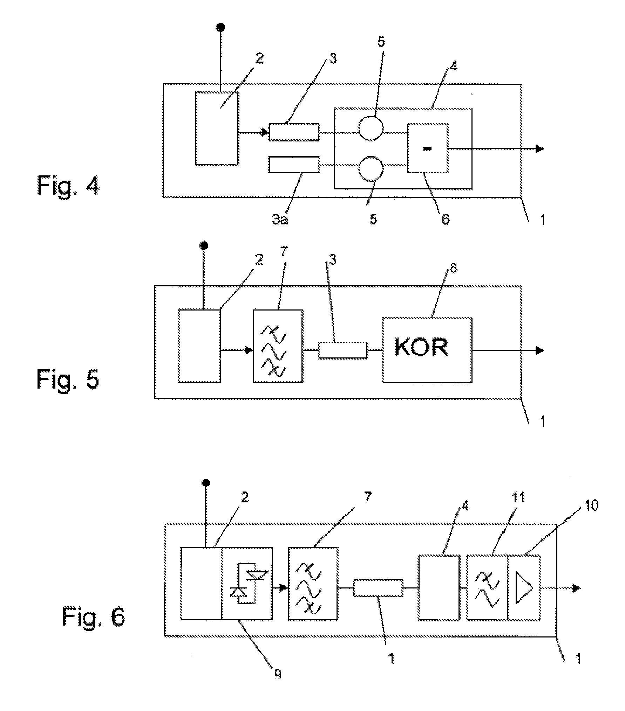

In Figur 4 ist eine alternative Weiterbildung zur in Figur 3 dargestellten Empfängervorrichtung 1 aufgezeigt. Im Unterschied zu Figur 3 weist Figur 4 eine Differenzeinheit 6 auf. Die Differenzeinheit 6 weist einen ersten und einen zweiten Eingang sowie einen Ausgang auf, wobei der erste Eingang mit dem Ausgang des Sensorelements verbunden ist, welches den variierenden physikalischen Parameter des resistiven Elements 3 detektiert. Der zweite Eingang der Differenzeinheit 6 ist mit dem Ausgang eines zweiten Sensorelements verbunden, welches den gleichen physikalischen Parameter eines resistiven Referenzelements 3a detektiert. Dieses resistive Referenzelement 3a ist bevorzugt genauso dimensioniert und in der gleichen Technologie hergestellt, wie das resistive Element 3. Das resistive Referenzelement 3a ist isoliert von der variierenden elektrischen Größe angeordnet. Am Ausgang der Differenzeinheit ist somit der relative Unterschied des variierenden physikalischen Parameters ohne additive Störeinflüsse abgreifbar.

In Figur 5 ist eine alternative Weiterbildung zur in Figur 3 dargestellten Empfängervorrichtung 1 aufgezeigt. Anstelle der Differenzeinheit 6 ist in Figur 5 eine Korrelationseinheit 8 vorgesehen. Diese Korrelationseinheit 8 ermittelt, ob das empfangene amplitudenmodulierte Signal für die Empfängervorrichtung vorgesehen ist. Auf Details der Korrelationseinheit 8 wird hier nicht eingegangen da diese dem Fachmann bekannt ist. Durch die Korrelationseinheit 8 ist die Empfindlichkeit der Empfängervorrichtung weiter gesteigert. Speziell stark verrauschte Signale können mittels Korrelation gut detektiert werden.

Zusätzlich ist zwischen resistivem Element 3 und der Antenne 2 ein Bandpassfilter 11 vorgesehen. Dieses Band begrenzende Element 7 begrenzt das empfangene Signal im Frequenzbereich und filtert die Frequenzanteile des Empfangssignals heraus, die nicht zum Informationsanteil des amplitudenmodulierten Signals gehören. Dieses Band begrenzende Element 7 ist insbesondere dann eingesetzt, wenn die Antenne 2 sehr breitbandig empfängt.

In Figur 6 ist eine alternative Weiterbildung zur in Figur 5 dargestellten Empfängervorrichtung 1 aufgezeigt. Zusätzlich weist die Empfängervorrichtung 1 im Empfangspfad zwischen Antenne 2 und Band begrenzendem Element 7 eine Überpegelschutzeinheit 9 auf. Wird der empfangene Pegel über einen bestimmten Pegelbereich hinaus empfangen, so begrenzt diese Überpegelschutzeinheit 9 diesen Pegel, um das resistive Element vor Zerstörung oder dem falschen detektieren zu schützen. Weiterhin ist nach der Auswerteeinheit 4 ein weiteres bandbegrenzendes Element, bevorzugt ein Tiefpassfilter 11, und ein verstärkendes Element 10 vorgesehen.

Allgemeingültig für die Empfängervorrichtung 1 ist auszusagen, dass zumindest das resistive Element 3 und die Auswerteeinheit als integrierte Schaltung auszuführen sind.

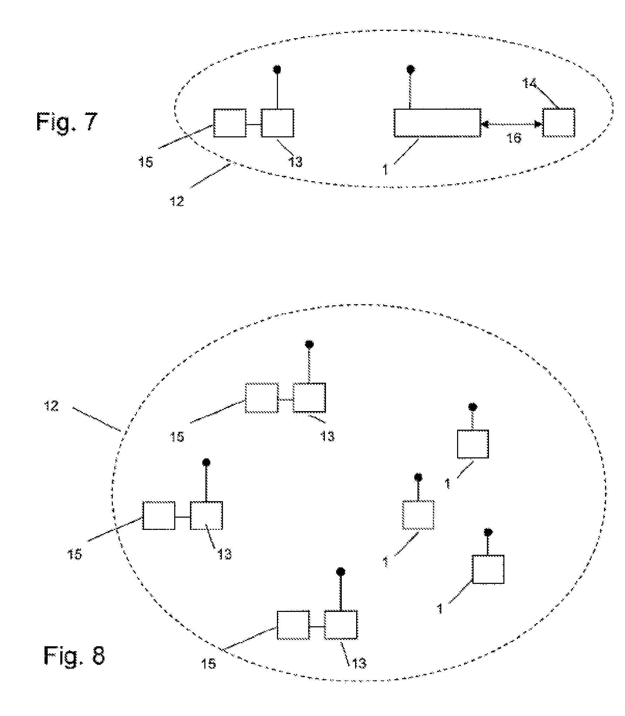

In Figur 7 ist ein System aufgezeigt, in dem eine Sendevorrichtung 13 die von Sensor 15 empfangenen Informationen mittels Amplitudenmodulation zu einer Empfängervorrichtung 1 sendet. Die Empfangsvorrichtung ist nach der oben beschriebenen Art aufgebaut. Die am Ausgang der Empfangsvorrichtung bereitgestellten Informationen werden mittels einer Bustopologie 16 an eine weiterverarbeitende Einheit 14 gesendet. Diese weiterverarbeitende Einheit 14 kann nun ein Aktor sein. Ein einfaches Beispiel ist ein Funkschalter. Der betätigte Schalter stellt hierbei den Sensor 15 dar, der die Information An bzw. Ausschalten einer bestimmten Einheit 14. Da die Einheit 14 eindeutig identifiziert sein muss, wird bevorzugt eine Identifikationsmarke als Information mit gesendet, die der richtigen Empfängervorrichtung 1 mittelt, dass genau sie angesprochen ist. Als Einheit 14 ist beispielsweise eine Lichtquelle, eine Motorsteuerung oder dergleichen denkbar. Als weiterverarbeitende Einheit 14 kann alternativ auch ein Datenverarbeitungssystem verstanden werden, welches die Sensordaten bzw. -informationen auswertet. Bevorzugt wird dieses System in der Gebäudetechnik eingesetzt.

Das System arbeitet mit energieärmeren Empfängervorrichtungen 1 und ist daher für den Einsatz in Energy Harvesting Systemen bevorzugt einzusetzen.

Das System weist alternativ zusätzlich noch energieautarke Knoten auf, die die Informationen bzw. Daten empfangen und verstärken. Ein solcher Knoten wird auch als Repeater bezeichnet und regeneriert das Informationssignal. Im Empfangsmodul des Knoten ist wiederum eine Empfängervorrichtung 1 wie in Figuren 2 bis 6 dargestellt, beschrieben. Eine Identifikationserkennung entfällt in den Knoten.

Dazu bezieht der Knoten seine Versorgungsenergie aus der Umgebung. Hierzu wird zumindest ein Wandler eingesetzt, der Umgebungsenergie in elektrische Energie umsetzt. Es können dabei auch mehrere Wandler mit zum Teil unterschiedlichen Wandelprinzipien eingesetzt sein. Beispielsweise ist die Versorgungsenergie mittels photovoltaischen Zellen gewonnen. Hierbei wird Strahlungsenergie, insbesondere Sonnenstrahlenenergie in elektrische Energie umgesetzt. Alternativ können auch mechanisch-elektrische Wandler eingesetzt sein, die beispielsweise einen Piezoelektrischen Effekt ausnutzen, um insbesondere Energie aus mechanischen Vibrationen in elektrische Versorgungsenergie umzusetzen. Alternativ ist der Einsatz von thermo-elektrischen Wandlern vorzusehen, die Temperaturänderungen der Umgebung, beispielsweise Wärmeabgabe von Maschinen und Motoren bzw. dem Tag/Nacht Temperaturunterschied ausnutzen, um elektrische Energie zu gewinnen. Alternativ ist auch der Einsatz von Windgeneratoren denkbar. Die Art der Energieerzeugung ist dabei in keiner Form beschränkt und eine beliebige Kombination unterschiedlicher Wandler ist dabei denkbar.

Durch diese energieautarken Knoten wird die Reichweite zwischen Sendevorrichtung 13 und Empfängervorrichtung 1 wesentlich erhöht.

In Figur 8 ist ein alternatives System dargestellt. Hierbei sind drei Sendevorrichtungen 13 vorgesehen und drei Empfangsvorrichtungen 1. Jede Sendevorrichtung 13 ist mit einem Sensor 15 verbunden und kann ein amplitudenmoduliertes Sendesignal erzeugen, welches eine spezielle Identifikationsmarke im Signal beinhaltet. Mit dieser Identifikationsmarke wird jeweils eine bestimmte Empfängervorrichtung 1 angesprochen. Die beiden anderen Empfangsvorrichtungen 1 ignorieren bei negativer Identifikationserkennung das empfangene Signal. So können beispielsweise drei Funkschalter über eine Sendefrequenz senden und die jeweils für den Empfang der Informationen vorgesehene Empfängervorrichtungen 1 empfängt die Daten richtig.

In Figur 9 ist zusätzlich eine Bustopologie 16 aufgezeigt, die eine Vernetzung von Empfängervorrichtungen 1 untereinander darstellt. Die Empfängervorrichtungen 1 weisen hierbei weiterhin Sendeelemente oder Verbindungselemente auf, um mit weiteren Empfangsvorrichtungen 1 zu kommunizieren.

Die vorgestellten Systeme sind vorrangig auch für Energie-Harvesting-Systeme vorgesehen. Als Energie-Harvesting-System werden hierbei energieautarke Empfangs- und Sendeeinrichtungen verstanden, die ihre zum Betrieb nötige Versorgung aus Umgebungsvariablen beziehen.

Zusätzlich ist ein Verfahren zum energiesparenden Empfangen eines mit Informationen amplitudenmodulierten Signals vorgesehen. Dazu ist in einer Empfangsvorrichtung 1 zunächst das Umsetzen einer veränderlichen elektromagnetischen Feldgröße in eine amplitudenmodulierte elektrische Größe mittels Antenne 2 durchzuführen. Im Folgeschritt wird die elektrische Größe in eine andere physikalische Größe mittels eines resistiven Elements 3 umgesetzt. Anschließend erfolgt die Auswertung zumindest einer der physikalischen Größen, die aufgrund der Amplitudenänderung variieren. Abschließend wird das Informationssignal bereitgestellt.

Alternativ wird während des Verfahrens die Auswertung mittels einer Differenzbildung mit einem Referenzwertdurchgeführt. Dadurch werden additive Störeinflüsse kompensiert.

Alternativ wird während des Verfahrens die Auswertung mittels einer Korrelation durchgeführt. Dadurch ist die Empfindlichkeit in der Empfängervorrichtung 1 weiter gesteigert.

Eine solche Empfängervorrichtung 1 findet beispielsweise Verwendung als Teil in einem Funksensornetz. Das Funksensornetz kann einige batteriebetriebene Vermittlungs- oder Verteilungsknoten aufweisen. Zusätzlich oder alternativ können diese Knoten energieautark, d.h. mit Umgebungsenergie betriebene Knoten sein. Informationen innerhalb des Funksensornetzes werden mittels geeigneter Routingverfahren weitergeleitet.

### Bezugszeichenliste

- 1: Empfängervorrichtung
- 2: Antenne
- 3: resistives Element
- 3a: resistives Referenzelement
- 4: Auswerteeinheit
- 5: Temperatursensor
- 6: Differenzeinheit
- 7: Band begrenzendes Element
- 8: Korrelationseinheit
- 9: Überpegelschutzeinheit
- 10: verstärkendes Element
- 11: Tiefpass
- 12: System
- 13: Sendevorrichtung
- 14: Nachgeschaltete Einheit
- 15: Aktor
- 16: Bustopologie
- 17: Reichweite
- 18: Unidirektionale Übertragung
- 19: Bidirektionale Übertragung
- 20: Informationssignal
- 21: Moduliertes Signal
- 22: Signalverlauf des variierenden physikalischen Parameters
- 23: detektiertes Informationssignal

## Patentansprüche

1. Empfängervorrichtung mit:
- einer Antenne, wobei die Antenne ausgebildet ist, eine mit Informationen amplitudenmodulierte elektrische Größe ausgangsseitig bereitzustellen,
- einem, der Antenne nachgeschalteten resistiven Element das durch die amplitudenmodulierte elektrische Größe belastet wird und
- einer, dem resistiven Element nachgeschalteten Auswerteeinheit, wobei die Auswerteeinheit:
- zumindest eine Änderung eines physikalischen Parameters des resistiven Elements in Vergleich zu einer Belastung mit einer unmodulierten elektrischen Größe auswertet,
- der physikalische Parameter aufgrund der Amplitudenmodulation der elektrischen Größe variiert und
- am Ausgang der Auswerteeinheit das Informationssignal bereitgestellt ist.

2. Empfängervorrichtung nach Anspruch 1, wobei ein physikalischer Parameter die Temperatur, eine geometrische Dimension, die Lichtstärke und/oder der elektrische Leitwert ist und/oder die Auswerteeinheit einen Messsensor für den physikalischen Parameter aufweist.

3. Empfängervorrichtung nach Anspruch 1 bis 2, wobei die Auswerteeinheit eine Differenzeinheit aufweist und diese Differenzeinheit:
- einen ersten und einen zweiten Eingang sowie einen Ausgang aufweist,
- am ersten Eingang der variierende physikalische Parameter des resistiven Elements in eine elektrische Größe umgesetzt angelegt ist
- am zweiten Eingang der gleiche physikalische Parameter eines resistiven Referenzelements unabhängig von dem von der Antenne bereitgestellten elektrischen Größe in eine elektrische Größe umgesetzt angelegt ist,
- am Ausgang die Differenz der beiden elektrischen Größen bereitgestellt ist.

4. Empfängervorrichtung nach einem der vorhergehenden Ansprüche, wobei zwischen Antenne und resistiven Element ein das Frequenzband der elektrischen Größe begrenzendes Element angeordnet ist und insbesondere die Auswerteeinheit eine Korrelationseinheit aufweist.

5. Empfängervorrichtung nach einem der vorhergehenden Ansprüche, wobei in der Empfängervorrichtung eine Überpegelschutzeinheit angeordnet ist, die derart mit der Antenne und dem resistiven Element gekoppelt ist, dass die Überpegelschutzeinheit die elektrische Größe nur weiterleitet, wenn der Empfangspegel für das resistive Element verarbeitbar ist.

6. Empfängervorrichtung nach einem der vorhergehenden Ansprüche, wobei in der Auswerteeinheit eine, das Informationssignal verstärkende und das Frequenzband der elektrischen Größe begrenzende Ausgangseinheit angeordnet ist.

7. Empfängervorrichtung nach einem der vorhergehenden Ansprüche, wobei zumindest das resistive Element und/ oder die Empfängervorrichtung als integrierter Schaltkreis in Mikrotechnik oder Nanotechnik ausgeführt ist.

8. System mit einer Sendevorrichtung und zumindest einer Empfängervorrichtung nach einem der vorhergehenden Ansprüche, wobei die Sendevorrichtung
- Daten oder Befehle eines Sensors oder Eingabegerätes aufnimmt,
- die Daten oder Befehle amplitudenmoduliert versendet und am Ausgang der Empfängervorrichtung die Daten oder Befehle als demoduliertes Signal bereitgestellt sind.

9. System nach Anspruch 8, wobei:
- mehrere Empfängervorrichtungen und mehrere Sendevorrichtungen im System angeordnet sind,
- jedes gesendete Signal eine Identifikationsmarke enthält,
- jeder Empfängervorrichtung eine Einheit nachgeschaltet ist und mit der Identifikationsmarke die nachgeschaltete Einheit einer bestimmte Empfängervorrichtung aktiviert wird und die nachgeschalteten Einheiten der übrigen Empfängervorrichtungen deaktiviert bleiben und wobei das System insbesondere vollasynchron arbeitet, und insbesondere die Empfängervorrichtung die Daten über ein Bussystem der nachgeschalteten Einheit bereitstellt, zusätzlich zumindest ein Knoten im System angeordnet ist, der als Repeater arbeitet und wobei der Knoten energieautark ist.

10. Verfahren zum energiesparenden Empfangen eines mit Informationen amplitudenmodulierten Signals in einer Empfängervorrichtung nach einem der Ansprüche 1 bis 7 mit den Verfahrensschritten:
- Umsetzen einer veränderlichen elektromagnetischen Feldgröße in eine amplitudenmodulierte elektrische Größe mittels Antenne,
- Umsetzen der elektrischen Größe in eine andere physikalische Größe mittels resistiven Elements,
- Auswerten zumindest einer der physikalischen Größen, die aufgrund der Amplitudenänderung variieren, im Vergleich zu einem Umsetzen einer unmodulierten elektrischen Größe in eine andere physikalische Größe,
- Bereitstellen des Informationssignals.

11. Verfahren nach Anspruch 10, wobei zur Auswertung eine Differenz mit einem Referenzwert gebildet wird.

12. Verfahren nach einem der Ansprüche 10 oder 11, wobei zur Auswertung eine Korrelation durchgeführt wird und/ oder zwischen dem Umsetzen in eine elektrische Größe und Umsetzen in eine physikalische Größe, die elektrische Größe bandbegrenzt wird.

13. Verfahren nach einem der Ansprüche 10 bis 12, wobei das resistive Element durch eine Überpegelschutzeinheit vor zu hohen Eingangspegeln geschützt wird und insbesondere nach dem Bereitstellen das Informationssignals verstärkt und bandbegrenzt wird.

14. Verwendung zumindest einer Empfängervorrichtung nach einem der Ansprüche 1 bis 12, oder eines Verfahrens nach einem der Ansprüche 10 bis 13 in einem Funksensornetz, wobei insbesondere eine der Empfängervorrichtungen in einem batteriebetriebenen Funksensorknoten des Funksensornetzes eingebracht ist und/ oder eine der Empfängervorrichtungen in einem mit Umgebungsenergie betriebenen Funksensorknoten des Funksensornetzes eingebracht ist.
